# EUROPÄISCHE PATENTSCHRIFT

(11) **EP 0 931 333 B1**
(45) Veröffentlichungstag und Bekanntmachung des Hinweises auf die Patenterteilung: **27.11.2002**
(21) Anmeldenummer: 97910214.2
(22) Anmeldetag: 19.09.1997
(51) Int. Cl.: H01L 21/3205, H01L 27/115

(54) **HERSTELLVERFAHREN FÜR EINE HOCH-EPSILON-DIELEKTRISCHE ODER FERROELEKTRISCHE SCHICHT**
PROCESS FOR THE MANUFACTURE OF A HIGHLY EPSILON-DIELECTRIC OR FERROELECTRIC COATING
PROCEDE DE FABRICATION D'UNE COUCHE HAUTEMENT EPSILON-DIELECTRIQUE OU FERROELECTRIQUE

(30) Priorität: 30.09.1996 DE 19640241
(43) Veröffentlichungstag der Anmeldung: 28.07.1999
(73) Patentinhaber: Infineon Technologies AG, 81669 München (DE)
(72) Erfinder: HARTNER, Walter, D-89441 Medlingen (DE); SCHINDLER, Günther, D-80802 München (DE); BRUCHHAUS, Rainer, D-80997 München (DE); PRIMIG, Robert, D-81541 München (DE)
(74) Vertreter: Zimmermann & Partner
(86) Internationale Anmeldenummer: DE9702131
(87) Internationale Veröffentlichungsnummer: WO98014993

(56) Entgegenhaltungen:
- EP-A- 0 380 326
- YAMAUCHI S ET AL: "QUASI-EPITAXIAL GROWTH OF PZT THIN FILM TO FABRICATE CAPACITOR SUITABLE FOR 256MB DRAM AND BEYOND" INTERNATIONAL CONFERENCE ON SOLID STATE DEVICES AND MATERIALS, 21.August 1995, Seiten 291-293, XP000544627
- CHEOL SEONG HWANG ET AL: "DEPOSITION OF EXTREMELY THIN (BA,SR)TIO3 THIN FILMS FOR ULTRA-LARGE-SCALE INTEGRATED DYNAMIC RANDOM ACCESS MEMORY APPLICATION" APPLIED PHYSICS LETTERS, Bd. 67, Nr. 19, 6.November 1995, Seiten 2819-2821, XP000544229 in der Anmeldung erwähnt

## Beschreibung

Die Erfindung betrifft ein Herstellverfahren für eine hoch-ε-dielektrische oder ferroelektrische Schicht auf einem Substrat, das insbesondere zur Herstellung eines integrierten Halbleiterspeichers verwendet wird.

Bei der Herstellung von integrierten Schaltungen gewinnen hoch-ε-dielektrische und ferroelektrische Substanzen zunehmend an Bedeutung. Sie werden beispielsweise als Kondensatordielektrikum in integrierten Speichern verwendet, da sie aufgrund ihrer hohen Dielektrizitätskonstante (εᵣ von einigen hundert) den Platzbedarf des Speicherkondensators verringern bzw. aufgrund der unterschiedlichen Polarisationsrichtungen des Ferroelektrikums den Bau eines nichtflüchtigen Speichers (FRAM) ermöglichen (kein Verlust der Information bei Ausfall der Versorgungsspannung und kein ständiger Refresh).

Beispiele für derartige Substanzen sind Barium-Strontium-Titanat(BST), Strontium-Titanat (ST) oder Blei-Zirkonium-Titanat (PZT), sowie SBT (SrBi₂Ta₂O₉), SBTN (SrBi₂Ta₂₋ₓNbₓO₉). Die Herstellung dieser Materialien erfolgt durch einen Sputter-, Spin-on- oder Abscheideprozeß, der hohe Temperaturen (≥ 700°C) in einer sauerstoffhaltigen Atmosphäre benötigt. Beim Einsatz in einer Speicherzelle, die beispielsweise als stacked capacitor aufgebaut ist, wird dann als Material für die erste Elektrode ein Edelmetall wie Platin oder Ruthenium verwendet, da die üblicherweise als Elektrodenmaterial eingesetzten leitfähigen Materialen wie Polysilizium oder Aluminium unter diesen Bedingungen oxidieren. Derartige edelmetallhaltige Elektroden sind jedoch sauerstoffdurchlässig, was zur Folge hat, daß während der Herstellung des Kondensatordielektrikums tieferliegende Strukturen oxidiert werden und ein ausreichender Kontakt zwischen erster Elektrode und dem Auswahltransistor der Speicherzelle nicht gewährleistet ist. Nach dem Stand der Technik ist daher eine Barriere unterhalb des Kondensatordielektrikums notwendig, die eine Sauerstoffdiffusion unterdrückt. Auch bei diesen Diffusionsbarrieren besteht jedoch die Gefahr der Oxidation während der Herstellung des Kondensatordielektrikums, so daß der elektrische Kontakt zwischen erster Elektrode und Auswahltransistor unterbrochen wird. Hauptgrund dafür ist neben der hohen Temperatur auch die lange Zeitdauer (bis zu 60 min) der Abscheidung bzw. Temperung.

Aus dem Artikel von S. Yamauchi et al., Intern. Conf. On Solid State Devices & Materials, 21 August 1995, Yokohama, Tokio, Japan, Seiten 291 - 293 und aus dem Dokument EP 0 380 326 sind jeweils Verfahren zur Herstellung von ferroelektrischen PZT-Schichten bekannt.

Aus dem Artikel von A. Yuuki et al, IEDM 95, Technical Digest, Seite 115, ist ein Verfahren bekannt, bei dem die Kristallisierung eines in einem CVD-Verfahren hergestellten BST-Films durch eine Temperung in N₂ erfolgt. Eine derartig hergestellte Schicht weist jedoch hohe Leckströme auf.

In dem Artikel von C. S. Hwang et al, Appl. Phys. Lett. 67 (1995) Seite 2819 beschreibt die Temperung von gesputterten BST-Schichten bei 550 bis 750°C in Stickstoff und Sauerstoff. Für die Herstellung einer Speicherzelle ist das Verfahren jedoch nicht geeignet, da die Temperung bei diesen Temperaturen in Sauerstoff die Barriere so stark oxidiert, daß die elektrische Verbindung zum Auswahltransistor unterbrochen wäre.

Die Erfindung hat daher zur Aufgabe, ein Herstellverfahren für eine hoch-ε-dielektrische Schicht oder eine ferroelektrische Schicht mit einer verringerten Temperaturbelastung anzugeben. Diese Aufgabe wird durch die Merkmale des Patentanspruchs 1 gelöst.

Bei der Erfindung wird ein Mehrstufenprozeß mit mindestens drei Schritten eingesetzt, um eine Oxidation der Barriere zu verhindern. Im ersten Schritt wird die Schicht bei einer niedrigen Substrattemperatur (T₁< 500°C) aufgesputtert. Die so erhaltene Schicht ist jedoch nicht kristallin bzw. hat eine sehr geringe Korngröße. Dies hat ein sehr geringes ε zur Folge. Der zweite Schritt ist ein RTP-Schritt (Rapid Thermal Processing) bei mittlerer bis hoher Temperatur (T₂: 500 bis 900°C, vorzugsweise 600 bis 800°C) in einer inerten Atmosphäre, die keinen Sauerstoff enthält. Besonders geeignet sind eine Stickstoff-Atmosphäre, Ar oder ein Ar/N₂-Gemisch. Die N₂-Atmosphäre verhindert eine Oxidation der Barriere, da der gesamte Sauerstoff in der Schicht gebunden ist. Nach diesem Schritt weist die Schicht ein hohes ε auf, hat jedoch hohe Leckströme, die auf Sauerstoffleerstellen in der Schicht zurückzuführen sind. Im dritten Schritt wird eine Nachtemperung bei niedriger oder mittlerer Temperatur (T₃: 200 bis 600°C, vorzugsweise 300 bis 500°C) in einer sauerstoffhaltigen Atmosphäre durchgeführt. Dabei wird der Schicht Sauerstoff zugeführt, und die Leckströme werden um mehrere Größenordnungen verringert. ε sinkt dabei nur geringfügig ab. Die Zeitdauer für die Nachtemperung kann bis zu 1h betragen (typischerweise 1 bis 15 min.), die Temperatur dieses Prozeßschritts darf nicht zu hoch gewählt werden, um eine Oxidation der Barriere zu verhindern.
- FIG 1: zeigt eine Speicherzelle einer integrierten Halbleiterschaltung, bei der das Verfahren eingesetzt werden kann,
- FIG 2: zeigt ein Temperatur-Zeit-Diagramm eines Ausführungsbeispieles der Erfindung.

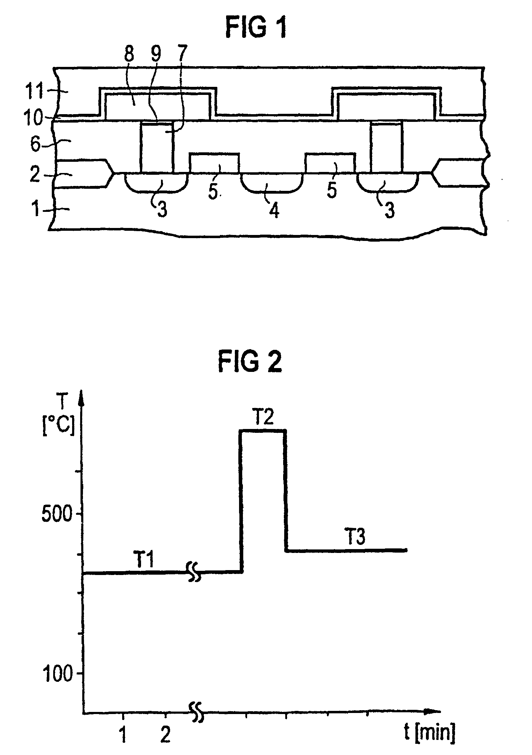

FIG 1: Als Beispiel für eine Anwendung des Verfahrens ist eine Zelle eines DRAM-Speichers mit einem über dem Auswahltransistor angeordneten Kondensator (Stacked-Zelle) dargestellt. Die FIG zeigt ein Silizium-Substrat 1 mit einem darin angeordneten MOS-Transistor, der zwei dotierte Gebiete 3, 4 und ein isoliert auf dem Substrat angebrachtes Gate 5 umfaßt. Nicht aktive Bereiche der Schaltung sind mit einer Isolation 2 bedeckt. Eine Isolationsschicht 6 bedeckt den Transistor, wobei ein Anschluß 7 zum dotierten Gebiet 3 und ein außerhalb der Zeichenebene liegender Anschluß zum dotierten Gebiet 4 vorgesehen sind. Der Anschluß 7 kann beispielsweise aus Polysilizium oder Wolfram bestehen, mit dem ein in die Isolationsschicht 6 geätztes Kontaktloch aufgefüllt wird. Dann wird mit einem bekannten Verfahren eine Diffusionsbarriere 9 aus Wolframnitrid (oder auch WTiN, TiN, TaN o.ä.) mit einer Dicke von 30 nm aufgebracht, so daß mindestens die gesamte freiliegende Oberfläche des Anschlusses 7 bedeckt ist. Anschließend wird eine erste Elektrode 8 aufgebracht, beispielsweise durch Sputtern oder MOCVD einer Platinschicht, und geeignet strukturiert. Die Barriere kann auch auf der Elektrode 8 angeordnet sein, oder es kann die Elektrode aus dem Barrierenmaterial geformt sein. Die soweit fertiggestellte Anordnung stellt einen Träger 1 - 9 für die hoch-ε-dielektrische oder ferroelektrische Schicht dar.Auf den Träger bzw. diese Elektrode 8 wird nun eine BST-Schicht als Kondensatordielektrikum 10 aufgebracht. Dafür wird ein 3-Stufen-Prozeß eingesetzt, bei dem im ersten Schritt das BST bei einer Substrattemperatur bis maximal 350°C aufgesputtert wird, die Schichtdicke beträgt etwa 10 - 200 nm. Das Substrat und die darauf abgeschiedene BST-Schicht werden nur während des Sputtervorgangs auf die Temperatur T₁ geheizt. Das dabei abgeschiedene BST ist aber noch nicht kristallin bzw. hat eine sehr geringe Korngröße. Nach dem Sputtern wird das BST in einem zweiten Schritt in einem RTP-Verfahren in einer Stickstoff-Atmosphäre kristallisiert. Die Temperatur beträgt dabei etwa 700°C, die Zeitdauer etwa 60 sec. Eine Oxidation der Barriere 9 wird durch die Stickstoff-Atmosphäre verhindert. Anschließend erfolgt der für die Funktion der BST-Schicht entscheidende dritte Schritt, nämlich eine etwa 3-min. Nachtemperung bei etwa 400°C in Luft, Sauerstoff oder einem O₂/N₂-Gemisch, wodurch dem BST Sauerstoff zugeführt und die Leckströme um mehrere Größenordnungen verringert werden. Der O₂-Partialdruck hat einen Einfluß auf die Qualität des BST. Mit dem beschriebenen mehrstufigen Prozeß können bei der beschriebenen Anordnung BST-Schichten mit ε > 200 und Leckströmen von etwa 10⁻⁸ A/cm² hergestellt werden. Schließlich wird die Speicherzelle durch Herstellen der zweiten Elektrode 11, beispielsweise aus Platin, vervollständigt.

FIG 2 zeigt das Temperatur-Zeit-Diagramm des in FIG 1 beschriebenen Herstellverfahrens.

## Patentansprüche

1. Herstellverfahren für eine hoch-ε-dielektrische oder eine ferroelektrische Schicht (10) auf einem Träger (1 bis 9) mit folgenden Schritten:
1) Aufsputtern der Schicht (10) bei einer niedrigen Temperatur T₁, die unter 500°C liegt,
2) Durchführen eines RTP-Schritts in einer inerten Atmosphäre bei einer Temperatur T₂, die im Bereich 500 - 900°C liegt,
3) Temperung der Schicht (10) in einer sauerstoffhaltigen Atmosphäre bei einer Temperatur T₃, die im Bereich 200 - 600°C liegt.

2. Herstellverfahren nach Anspruch 1, bei dem die Temperatur T₂ im Bereich von 600 bis 800°C liegt.

3. Herstellverfahren nach einem der Ansprüche 1 bis 2, bei dem die Temperatur T₃ im Bereich von 300 bis 500°C liegt.

4. Herstellverfahren nach einem der Ansprüche 1 bis 3, bei dem der zweite Schritt einer stickstoffhaltigen Atmosphäre durchgeführt wird.

5. Herstellverfahren nach einem der Ansprüche 1 bis 4, bei dem die Atmosphäre im dritten Schritt aus Sauerstoff oder Luft besteht und die Zeitdauer 1 bis 15 min. beträgt.

6. Verwendung des Verfahrens nach einem der Ansprüche 1 bis 5 bei der Herstellung eines Kondensatordielektrikums in einer integrierten Speicherzelle.

## Claims

1. Method for fabricating a high-ε dielectric layer or a ferroelectric layer (10) on a substrate (1-9), comprising the following steps:
1) Sputtering on the layer (10) at a low temperature T₁ which is below 500°C,
2) Carrying out an RTP step in an inert atmosphere at a temperature T₂ which lies in the range from 500-900°C,
3) Conditioning the layer (10) in an oxygen-containing atmosphere at a temperature T₃ which lies in the range 200-600°C.

2. Fabrication method according to Claim 1, in which the temperature T₂ lies in the range from 600 to 800°C.

3. Fabrication method according to one of Claims 1 to 2, in which the temperature T₃ lies in the range from 300 to 500°C.

4. Fabrication method according to one of Claims 1 to 3, in which the second step is carried out [lacuna] a nitrogen-containing atmosphere.

5. Fabrication method according to one of Claims 1 to 4, in which the atmosphere in the third step consists of oxygen or air and the duration is 1 to 15 min.

6. Use of the method according to one of Claims 1 to 5 for the fabrication of a capacitor dielectric in an integrated memory cell.

## Revendications

1. Procédé de fabrication d'une couche (10) fortement ε-diélectrique ou d'une couche (10) ferroélectrique sur un support (1 à 9) comprenant les stades suivants :
1) dépôt par pulvérisation cathodique de la couche (10) à une température T₁ basse qui est inférieure à 500°C,
2) mise en oeuvre d'un stade RTP dans une atmosphère inerte à une température T₂ qui est de l'ordre de 500 à 900°C,
3) traitement thermique de la couche (10) dans une atmosphère contenant de l'oxygène à une température T₃ qui est de l'ordre de 200 à 600°C.

2. Procédé de fabrication suivant la revendication 1, dans lequel la température T₂ est de l'ordre de 600 à 800°C.

3. Procédé de fabrication suivant l'une des revendications 1 à 2, dans lequel la température T₃ est de l'ordre de 300 à 500°C.

4. Procédé de fabrication suivant l'une des revendications 1 à 3, dans lequel le deuxième stade est effectué dans une atmosphère contenant de l'azote.

5. Procédé de fabrication suivant l'une des revendications 1 à 4, dans lequel l'atmosphère dans le troisième stade est constituée d'azote ou d'air, et la durée du stade est de 1 à 15 minutes.

6. Utilisation du procédé suivant l'une des revendications 1 à 5 pour la fabrication d'un diélectrique de condensateur dans une cellule intégrée de mémoire.
